# EUROPÄISCHE PATENTANMELDUNG

(11) **EP 1 437 798 A1**
(43) Veröffentlichungstag der Anmeldung: **14.07.2004**
(21) Anmeldenummer: 04000088.7
(22) Anmeldetag: 07.01.2004
(51) Int. Cl.: H01R 9/11, H01R 9/24, H01R 13/631

(54) **Anschlussvorrichtung einer mehradrigen Anschlussleitung mit einer in einem Gehäuse unterbringbaren Leiterplatte**

(30) Priorität: 11.01.2003 DE 10300768
(71) Anmelder: Hella KG Hueck & Co., 59552 Lippstadt (DE)
(72) Erfinder: Vollmert, Klaus, 59558 Lippstadt (DE); Winter, Michael, 59063 Hamm (DE)

(57) **Zusammenfassung**

Die Erfindung betrifft eine Anschlussvorrichtung für die Verbindung einer mehradrigen Anschlussleitung mit einer in einem Gehäuse unterbringbaren Leiterplatte, umfassend Anbringmittel (4) für die Anbringung der Anschlussvorrichtung an oder in dem Gehäuse, Positioniermittel für die Positionierung der Adern (2) der Anschlussleitung (1) für deren Verbindung mit der Leiterplatte, wobei die Positioniermittel als Durchführleiste (5) mit einer Mehrzahl von Öffnungen (7) für die Hindurchführung der Adern (2) ausgebildet sind.

## Beschreibung

### STAND DER TECHNIK

Die vorliegende Erfindung betrifft eine Anschlussvorrichtung für die Verbindung einer mehradrigen Anschlussleitung mit einer in einem Gehäuse unterbringbaren Leiterplatte, umfassend Anbringmittel für die Anbringung der Anschlussvorrichtung an oder in dem Gehäuse sowie Positioniermittel für die Positionierung der Adern der Anschlussleitung für deren Verbindung mit der Leiterplatte.

Gemäß dem Stand der Technik besteht die Möglichkeit, bei der Montage von Adern einer Anschlussleitung an Leiterplatten die einzelnen Adern Stück für Stück in entsprechende Löcher der Leiterplatte zu bestücken. Eine derartige Verbindung dauert vergleichsweise lange und ist schwer durchführbar. Insbesondere dann, wenn der Montageort nicht einsichtig ist, ist eine derartige Verbindung von Leitungen mit einer Leiterplatte praktisch unmöglich. Es gibt Anschlussvorrichtungen der vorgenannten Art, bei denen die Adern gebündelt und grob vorpositioniert werden. Die Positionierung ist hierbei jedoch vergleichsweise schlecht, so dass die einzelnen Adern in der Regel nicht exakt an der Stelle angeordnet sind, an der letztlich auf der Leiterplatte Löcher bestückt werden müssen. Eine verdeckte Montage ist mit derartigen Positioniermitteln nicht möglich.

Weiterhin ist es aus dem Stand der Technik bekannt, die einzelnen Adern in den Anbringmitteln mit Schmelzkleber zu umschließen, um dadurch eine Vorpositionierung zu erreichen. Das Problem ist hierbei, dass Schmelzkleber relativ weich sind und beim Löten zum Aufschmelzen neigen, wodurch die Qualität, der angestrebten Lötverbindung geschmälert wird.

Das der vorliegenden Erfindung zugrundeliegende Problem ist die Schaffung einer Anschlussvorrichtung der eingangs genannten Art, mittels der einfach und zuverlässig eine mehradrige Anschlussleitung mit einer Leiterplatte verbunden werden kann.

Dies wird erfindungsgemäß dadurch erreicht, dass die Positioniermittel als Durchführleiste mit einer Mehrzahl von Öffnungen für die Hindurchführung der Adern ausgebildet sind. Die Öffnungen in der Durchführleiste können dabei exakt so angeordnet sein wie die Löcher in der Leiterplatte, die mit den Adern bestückt werden müssen. Eine derartig gestaltete Durchführleiste stellt somit ein sehr einfaches aber doch effektives Positioniermittel dar.

Gemäß einer bevorzugten Ausführungsform der vorliegenden Erfindung weisen die Öffnungen in der Durchführleiste einen Innendurchmesser auf, der etwa so groß wie der Außendurchmesser der Adern ist. Die Öffnungen sind somit eng auf die entsprechenden Adern abgestimmt, so dass die Adern zum einen sehr genau positioniert werden und zum anderen in der Durchführleiste sicher und fest gehalten werden.

Vorteilhafterweise umfassen die Anbringmittel eine Anlagefläche, die an der Innenseite des Gehäuses anliegen kann. Die Anbringmittel gewährleisten somit eine sichere Montage der Anschlussvorrichtung und dem Gehäuse.

Insbesondere kann hierbei vorgesehen sein, dass sich von der Anlagefläche Zapfen durch entsprechende Öffnungen in dem Gehäuse hindurcherstrecken können. Die Zapfen gewährleisten beispielsweise nach einer Ausformung als Pilskopfzapfen einen sicheren Halt der Anbringmittel an dem Gehäuse.

Gemäß einer bevorzugten Ausführungsform der vorliegenden Erfindung sind die Anbringmittel und die Durchführleiste miteinander verbunden. Die Anbringmittel gewährleisten somit ebenfalls den sicheren Halt der Durchführleiste an der gewünschten Position im Innern des Gehäuses und somit in der gewünschten Ausrichtung zur Leiterplatte.

Erfindungsgemäß kann vorgesehen sein, dass die Anbringmittel und die Durchführleiste über eine vorzugsweise adhäsive Weichkomponente miteinander verbunden sind. Eine derartige Verbindung ist vergleichsweise einfach herstellbar.

Zusätzlich kann vorgesehen sein, dass die Adern der Anschlussleitung fest mit den Anbringmitteln und/oder der Durchführleiste verbunden sind. Auch hier besteht insbesondere die Möglichkeit, die Adern der Anschlussleitung über eine vorzugsweise adhäsive Weichkomponente mit den Anbringmitteln und/oder der Durchführleiste zu verbinden. Die exakte Positionierung der beispielsweise als verzinnte Litzen ausgeführten Aderenden in dem Gehäuse beziehungsweise in Bezug auf die Leiterplatte wird durch diese mehrfachen Verbindungen zwischen Anbringmitteln und Durchführleiste beziehungsweise Adern und Durchführleiste sicher gewährleistet. Gleichzeitig wird durch die Anbringmittel eine sehr einfache Montage an dem Gehäuse ermöglicht, wobei durch die Verbindung von Adern und Anbringmitteln und/oder Durchführleiste auch auf die Anschlussleitung einwirkende Zugkräfte problemlos über die Anbringmittel auf das Gehäuse übertragen werden können. Weiterhin wird durch die Verbindung der Anbringmittel und der Durchführleiste sowie der Adern über die Weichkomponente eine vereinfachte Vormontage beispielsweise bei einem Zulieferer ermöglicht.

### ZEICHNUNGEN

Weitere Vorteile und Merkmale der vorliegenden Erfindung werden deutlich anhand der nachfolgenden Beschreibung bevorzugter Ausführungsbeispiele unter Bezugnahme auf die beiliegenden Abbildungen. Darin zeigen
- Fig. 1: eine schematische Ansicht einer erfindungsgemäßen Anschlussvorrichtung mit integrierter Anschlussleitung;
- Fig. 2: eine perspektivische Ansicht einer Durchführleiste einer erfindungsgemäßen Anschlussvorrichtung;
- Fig. 3: eine Fig. 2 entsprechende Ansicht mit durch die Öffnungen der Durchführleiste hindurchgeführten Adern der Anschlussleitung;
- Fig. 4: eine perspektivische Ansicht auf Anbringmitteln einer erfindungsgemäßen Anschlussvorrichtung;
- Fig. 5: eine perspektivische Ansicht von miteinander verbundenen Anbringmitteln und Durchführleiste bei durch die Öffnungen der Durchführleiste hindurchgeführten Adern der Anschlussleitung;
- Fig. 6: eine perspektivische Ansicht einer Weichkomponente einer erfindungsgemäßen Anschlussvorrichtung.

### BESCHREIBUNG DER AUSFÜHRUNGSBEISPIELE

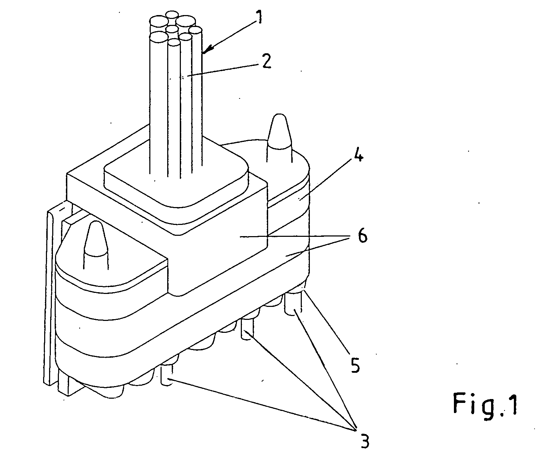

Wie aus Fig. 1 ersichtlich ist, umfasst eine erfindungsgemäße Anschlussvorrichtung für eine Anschlussleitung 1 mit mehreren Adern 2 Anbringmittel 4, die über eine Weichkomponente 6 mit einer Durchführleiste 5 verbunden sind. Durch die Durchführleiste 5 erstrecken sich verzinnte Litzen 3 der Adern 2.

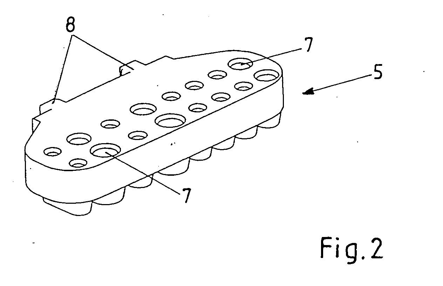

Die Durchführleiste 5 ist aus Fig. 2 detailliert ersichtlich. Die Durchführleiste 5 weist Öffnungen 7 auf, durch die hindurch sich die Litzen 3 hindurch erstrecken können. Die Öffnungen 7 sind dabei derart eng auf die Adern 2 beziehungsweise die Litzen 3 abgestimmt, dass diese sehr genau positioniert und gehalten werden. Die Durchführleiste 5 weist weiterhin an ihrer in Fig. 2 hinteren Seite Anformungen 8 auf, die zur mechanischen Verbindung mit den Anbringmitteln 4 dienen.

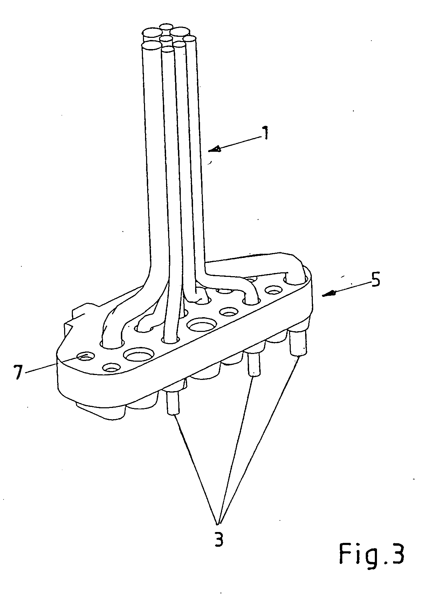

Aus Fig. 3 ist noch einmal deutlich ersichtlich, wie die Adern 2 der Anschlussleitung 1 durch die Öffnungen 7 hindurchgeführt werden und in verzinnten Litzen 3 enden.

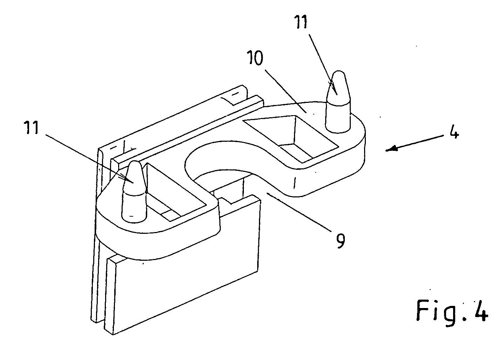

Aus Fig. 4 sind die Anbringmittel 4 ersichtlich, die eine Anlagefläche 10 mit einer darin angeordneten Aussparung 9 für die Anschlussleitung 1 aufweisen. Die Anlagefläche 10 dient beispielsweise für die Anlage der Anbringmittel 4 an der Innenseite eines Gehäuses. Von der Anlagefläche 10 erstrecken sich Zapfen 11 in Fig. 4 nach oben, die sich bei an der Innenseite eines Gehäuses anliegender Anlagefläche 10 durch entsprechende Öffnungen in dem Gehäuse hindurch erstrecken können, um eine sichere Verbindung der Anbringmittel 4 mit dem Gehäuse zu gewährleisten.

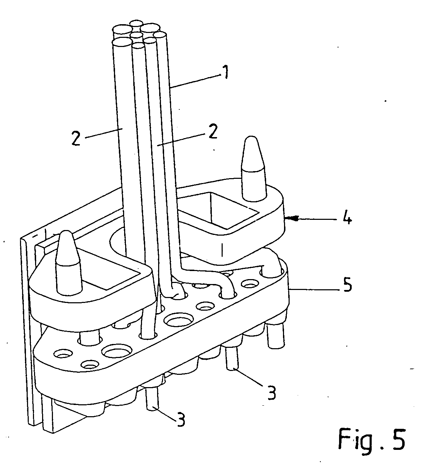

In Fig. 5 ist dargestellt, wie die Durchführleiste 5 mit den Anbringmitteln 4 mechanisch verbunden ist. Weiterhin ist in Fig. 5 dargestellt, wie sich die Adern 2 der Anschlussleitung 1 durch die Anbringmittel 4, insbesondere durch deren Aussparung 9 hindurch erstrecken und in die Öffnungen 7 der Durchführleiste 5 hineinverlaufen.

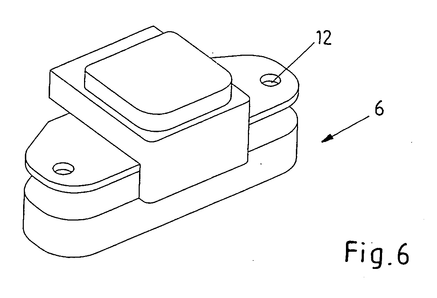

Diese in Fig. 5 mechanisch realisierte Verbindung zwischen Durchführleiste 5 und Anbringmitteln 4 wird durch die in Fig. 6 dargestellte Weichkomponente 6 befestigt. Diese Weichkomponente kann beispielsweise als Schmelzkleber ausgebildet sein. Durch diese Weichkomponente werden nicht nur die Anbringmittel 4 und die Durchführleiste 5 miteinander verbunden, sondern auch die Adern 2 der Anschlussleitung 1 mit den Anbringmitteln 4 und der Durchführleiste 5 verbunden. Aus Fig. 6 ist ebenfalls entnehmbar, dass die Weichkomponente 6 einen sich auf der Oberseite der Anlagefläche 10 erstreckenden Bereich mit Öffnungen 12 für den Hindurchtritt der Zapfen 11 aufweist (siehe dazu auch Fig. 1 und Fig. 4).

## Patentansprüche

1. Anschlussvorrichtung für die Verbindung einer mehradrigen Anschlussleitung mit einer in einem Gehäuse unterbringbaren Leiterplatte, umfassend
- Anbringmittel (4) für die Anbringung der Anschlussvorrichtung an oder in dem Gehäuse;
- Positioniermittel für die Positionierung der Adern (2) der Anschlussleitung (1) für deren Verbindung mit der Leiterplatte;
**dadurch gekennzeichnet, dass** die Positioniermittel als Durchführleiste (5) mit einer Mehrzahl von Öffnungen (7) für die Hindurchführung der Adern (2) ausgebildet sind.

2. Anschlussvorrichtung nach Anspruch 1, **dadurch gekennzeichnet, dass** die Öffnungen (7) in der Durchführleiste (5) einen Innendurchmesser aufweisen, der etwa so groß wie der Außendurchmesser der Adern (2) ist.

3. Anschlussvorrichtung nach einem der Ansprüche 1 oder 2, **dadurch gekennzeichnet, dass** die Anbringmittel eine Anlagefläche (10) umfassen, die an der Innenseite des Gehäuses anliegen kann.

4. Anschlussvorrichtung nach Anspruch 3, **dadurch gekennzeichnet, dass** sich von der Anlagefläche (10) Zapfen durch entsprechende Öffnungen in dem Gehäuse hindurch erstrecken können.

5. Anschlussvorrichtung nach einem der Ansprüche 1 bis 4, **dadurch gekennzeichnet, dass** die Anbringmittel (4) und die Durchführleiste (5) miteinander verbunden sind.

6. Anschlussvorrichtung nach Anspruch 5, **dadurch gekennzeichnet, dass** die Anbringmittel (4) und die Durchführleiste (5) über eine vorzugsweise adhäsive Weichkomponente miteinander verbunden sind.

7. Anschlussvorrichtung nach einem der Ansprüche 1 bis 6, **dadurch gekennzeichnet, dass** die Adern (2) der Anschlussleitung (1) fest mit den Anbringmitteln (4) und/oder der Durchführleiste (5) verbunden sind.

8. Anschlussvorrichtung nach Anspruch 7, **dadurch gekennzeichnet, dass** die Adern (2) der Anschlussleitung (1) über eine vorzugsweise adhäsive Weichkomponente mit den Anbringmitteln (4) und/oder der Durchführleiste (5) verbunden sind.
